# EUROPEAN PATENT APPLICATION

(11) **EP 4 125 120 A2**
(43) Date of publication of application: **01.02.2023**
(21) Application number: 22180899.1
(22) Date of filing: 24.06.2022
(51) Int. Cl.: H01L 23/485, H01L 21/60, H01L 23/498

(54) **ELECTRONIC APPARATUS WITH AN ELECTRONIC COMPONENT DISPOSED ON AND ELECTRICALLY CONNECTED TO A SUBSTRATE WITH AT LEAST ONE SPACER INTERPOSED THEREBETWEEN**

(30) Priority: 09.07.2021 US 202163219832 P; 12.04.2022 CN 202210380862
(71) Applicant: InnoLux Corporation, Chu-Nan, Miao-Li County 35053 (TW)
(72) Inventor: CHI, Jen-Hai, 35053 Chu-Nan, Miao-Li County (TW); HSIEH, Chih-Yung, 35053 Chu-Nan, Miao-Li County (TW); HO, Chia-Chi, 35053 Chu-Nan, Miao-Li County (TW)
(74) Representative: Becker, Eberhard

(57) **Abstract**

An electronic apparatus (100a,100b,100c,100d,100e,100f,100g,100h) includes a substrate (110), a plurality of bonding pads (115,115g,160), an electronic device (120), and a first spacer (130a,130b,130c,130d,130e,130f,130h). The electronic device (120) is disposed on the substrate (110) and electrically connected to the substrate (110) through the first bonding pads (115), in particular, flip-chip bonded thereto. The first spacer (130a,130b,130c,130d,130e,130f,130h) is disposed between the electronic device (120) and the substrate (110). The bonding pads may be first bonding pads (115,115g) disposed on the substrate (110). The first spacer (130a) may be disposed between the first bonding pads (115), wherein a second spacer (140a) may further be disposed between the first bonding pads (115). Alternatively, the first bonding pads (115) may be disposed between the first spacer (130b) and a second spacer (140b). The spacers (130a, 130b, 140a, 140b) may be rectangular. Four first spacers (130c) (for instance, ball-shaped) may be respectively arranged around the first bonding pads (115), at positions corresponding to corners of the electronic device (120). The first spacer (130d,130e) may surround the first bonding pads (115), in particular, it may have an H shape in top view and surround three side surfaces of the first bonding pads (115). A plurality of second bonding pads (125,125g) may be disposed on the electronic device (120), wherein the first spacer (130f) may be disposed between the second bonding pads (125) and the first bonding pads (115) on the substrate (110), wherein the first spacer (130f) may further comprise a solder ball. The first bonding pads (115,115g) and the second bonding pads (125g,125g) may be structurally and electrically connected through a plurality of solder materials (150), wherein a shape of the first spacer (130e) may be rectangular, the first spacer (130e) having two openings (132), the first bonding pads (115), the solder materials (150), and the second bonding pads (125) being located in the two openings (132) and the first spacer (130e) surrounding the first bonding pads (115). The first bonding pads (115g) and the second bonding pads (125g) may have an L shape in top view. The electronic apparatus (100h) may comprise a plurality of spacers (130h), disposed on one of the electronic device (120) and the substrate (110), and a plurality of bonding pads (160), disposed on the other of the electronic device (120) and the substrate (110), wherein the substrate (110) and the electronic device (120) are electrically connected through the spacers (130h) and the bonding pads (160), wherein a solder material (150h) may be located between the spacers (130h) and the bonding pads (160).

The spacer (130a,130b,130c,130d,130e,130f,130h,140a,140b) allows for effectively controlling a height and uniformity of a gap between the electronic device (120) and the substrate (110), so as to prevent the electronic device (120) from being tilted during solder reflow and ensure the electronic apparatus (100a,100b,100c,100d,100e,100f,100g,100h) to have a favorable structural reliability.

## Description

### BACKGROUND

### Technical Field

The disclosure relates to an electronic apparatus; more particularly, the disclosure relates to an electronic apparatus with a favorable structural reliability.

### Description of Related Art

A flip chip packaging technology is a widely applied semiconductor packaging technology at present. According to the flip chip packaging technology, an electronic device is often soldered to a substrate through a solder material. However, in a reflowing process, the solder material is in a molten state, and thus it is difficult to control the thickness of the solder material during the reflowing process, which may easily lead to distortion of the electronic device disposed on the substrate. Hence, how to effectively prevent the electronic device from being tilted and other relevant defects caused by the reflow process is one of the issues to which research and development personnel are endeavored to resolve.

### SUMMARY

The disclosure provides an electronic apparatus with a favorable structural reliability.

In an embodiment of the disclosure, an electronic apparatus including a substrate, a plurality of first bonding pads, an electronic device, and a first spacer is provided. The first bonding pads are disposed on the substrate. The electronic device is disposed on the substrate and electrically connected to the first bonding pads. The first spacer is disposed between the electronic device and the substrate.

In an embodiment of the disclosure, an electronic apparatus including a substrate, an electronic device, a plurality of spacers, and a plurality of bonding pads is provided. The electronic device is disposed on the substrate. The spacers are disposed on one of the electronic device and the substrate. The bonding pads are disposed on the other of the electronic device and the substrate. The substrate and the electronic device are electrically connected through the spacers and the bonding pads.

In view of the above, according to one or more embodiments of the disclosure, the spacer is disposed between the electronic device and the substrate, so as to effectively control a height and uniformity of a gap between the electronic device and the substrate, whereby the electronic device may be prevented from being tilted. As a result, the electronic device provided in one or more embodiments of the disclosure may have a favorable structural reliability.

To make the above more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles provided in the disclosure.
FIG. 1A is a schematic top view of an electronic apparatus according to an embodiment of the disclosure.
FIG. 1B is a schematic cross-sectional view taken along a line I-I depicted in FIG. 1A.
FIG. 2A is a schematic top view of an electronic apparatus according to another embodiment of the disclosure.
FIG. 2B is a schematic cross-sectional view taken along a line II-II depicted in FIG. 2A.
FIG. 3 is a schematic top view of an electronic apparatus according to another embodiment of the disclosure.
FIG. 4 is a schematic top view of an electronic apparatus according to another embodiment of the disclosure.
FIG. 5A is a schematic top view of an electronic apparatus according to another embodiment of the disclosure.
FIG. 5B is a schematic cross-sectional view taken along a line III-III depicted in FIG. 5A.
FIG. 6 is a schematic cross-sectional view of an electronic apparatus according to another embodiment of the disclosure.
FIG. 7 is a schematic top view of an electronic apparatus according to another embodiment of the disclosure.
FIG. 8 is a schematic cross-sectional view of an electronic apparatus according to another embodiment of the disclosure.

### DESCRIPTION OF THE EMBODIMENTS

The disclosure may be understood by referring to the following detailed description with reference to the accompanying drawings. It is noted that for comprehension of the reader and simplicity of the drawings, in the drawings provided in the disclosure, only a part of the electronic apparatus is shown, and certain devices in the drawings are not necessarily drawn to actual scale. Moreover, the quantity and the size of each device in the drawings are only schematic and exemplary and are not intended to limit the scope of protection provided in the disclosure.

Certain words will be used to refer to specific devices throughout the specification and the appended claims of the disclosure. People skilled in the art should understand that manufacturers of electronic devices may refer to same components under different names. The disclosure does not intend to distinguish devices with the same functions but different names.

In the following specification and claims, the terminologies "having", "including", etc. are open-ended terminologies, so they should be interpreted to mean "including but not limited to ...".

In addition, relative terminologies, such as "below" or "bottom" and "above" or "top" may be used in the embodiments to describe the relative relationship between one component and another component in the drawings. It can be understood that if a device in the drawing is turned upside down, the device described on the "lower" side becomes the device on the "upper" side.

In some embodiments of the disclosure, unless specifically defined, terminologies related to bonding and connection such as "connected", "interconnected", etc. may mean that two structures are in direct contact, or that two structures are not in direct contact with other structures provided therebetween. The terminologies related to bonding and connection may also cover cases where two structures are both movable or two structures are both fixed. In addition, the terminology "coupling" includes the transfer of energy between two structures through direct or indirect electrical connection or the transfer of energy between two separate structures through mutual induction.

It should be understood that when a device or a film layer is described as being "on" or "connected to" another device or film layer, it may be directly on or connected to the another device or film layer, or there is an intervening device or film layer therebetween (i.e., indirect connection). Conversely, when a device or film layer is described as being "directly on" or "directly connected to" another device or film layer, there is no intervening device or film layer therebetween.

The terminologies "about", "equal to", "equivalent to" or "same", "substantially" or "approximately" are generally interpreted as being within 20% of a given value or range, or interpreted as being within 10%, 5%, 3%, 2%, 1%, or 0.5% of a given value or range.

As used herein, the terminologies "film" and/or "layer" may refer to any continuous or discontinuous structure and material (such as materials deposited by the methods disclosed herein). For example, the film and/or layer may include two-dimensional materials, three-dimensional materials, nanoparticles, or even partial or complete molecular layers, or partial or complete atomic layers, or clusters of atoms and/or molecules. The film or layer may include a material or a layer having pinholes, which may be at least partially continuous.

The terminologies such as "first", "second", "third", etc. may be used to describe components, but the components should not be limited by these terminologies. The terminologies are only intended to distinguish a component from another component in the specification. It is possible that the claims do not use the same terminologies and replace the terminologies with "first", "second", "third" etc. according to the sequence provided in the claims. Accordingly, in the specification, a first component may be a second component in the claims.

Unless otherwise defined, all terminologies (including technical and scientific terminologies) used herein have the same meanings commonly understood by those having ordinary skill in the art. It is understandable that these terminologies, such as those defined in commonly used dictionaries, should be interpreted as having a meaning consistent with the relevant technology and the background or context of this disclosure, rather than being interpreted in an idealized or overly formal way, unless specifically defined here.

It should be understood that the following embodiments may replace, reorganize, and mix the features in several different embodiments to complete other embodiments without departing from the spirit of the disclosure. As long as the features of the embodiments do not violate the spirit of the disclosure or conflict each other, they may be mixed and matched as desired.

The electronic apparatus provided in the disclosure may include a display apparatus, an antenna apparatus, a sensing apparatus, a light-emitting apparatus, or a tiling apparatus, but is not limited thereto. The electronic apparatus may be a bendable or flexible electronic apparatus. The electronic apparatus may include electronic components. Electronic components can include passive components, active components or the combination thereof, such as capacitors, resistors, inductors, variable capacitors, filters, diodes, transistors, sensors, microelectromechanical system (MEMS) components, and liquid crystal chips etc., but not limited thereto. The diode may include light emitting diode or non-light emitting diode. The diode may include P-N junction diode, PIN diode, or constant current diodes. Light emitting diodes may include, for example, organic light emitting diodes (OLED), mini LED, micro LED, quantum dot LED, fluorescence, phosphor or other suitable materials, or a combination of the above, but not limited thereto. The sensor may, for example, include capacitive sensors, optical sensors, electromagnetic sensors, fingerprint sensors (FPS), touch sensors, antenna, or pen sensor, etc., but not limited thereto. Hereinafter, the display apparatus will be used as an electronic apparatus to illustrate the content of the disclosure, but the disclosure is not limited thereto.

Reference will now be made in detail to the exemplary embodiments of the disclosure, and examples of the exemplary embodiments are illustrated in the accompanying drawings. Whenever possible, the same reference symbols are used in the drawings and descriptions to indicate the same or similar parts.

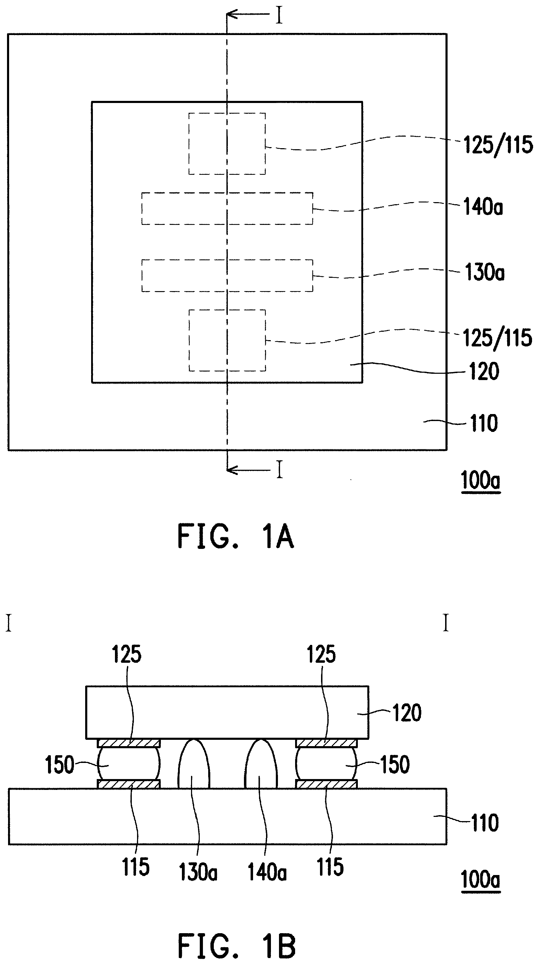

FIG. 1A is a schematic top view of an electronic apparatus according to an embodiment of the disclosure. FIG. 1B is a schematic cross-sectional view taken along a line I-I depicted in FIG. 1A. For clarity of the drawings, a solder material 150 depicted in FIG. 1B is omitted from FIG. 1A. With reference to FIG. 1A and FIG. 1B, in this embodiment, an electronic apparatus 100a includes a substrate 110, a plurality of first bonding pads 115 (two of which are schematically shown), an electronic device 120, and a first spacer 130a. The first bonding pads 115 are disposed on the substrate 110. The electronic device 120 is disposed on the substrate 110 and electrically connected to the first bonding pads 115. The first spacer 130a is disposed between the electronic device 120 and the substrate 110.

Specifically, in this embodiment, the substrate 110 includes a motherboard and a circuit located on the motherboard, and the motherboard may be, for instance, a glass substrate, a glass fiber (FR4) substrate, a flexible plastic substrate, a thin film transistor (TFT) substrate, a flexible substrate, or any other appropriate motherboard, which should not however be construed as a limitation in the disclosure. The electronic device 120 is, for instance, a light emitting diode (LED) die, which may be made of silicon (Si), gallium arsenide (GaAs), gallium nitride (GaN), silicon carbide (SiC), or a die made of sapphire or a glass substrate, which should however not be construed as a limitation in the disclosure. In another embodiment, the die may also be a semiconductor package device, such as a ball grid array (BGA) package device, a chip size package (CSP) device, a flip chip die, or a 2.5D/3D package device, which should however not be construed as a limitation in the disclosure. In another embodiment, the die may also be any kind of flip chip die bonding device, such as an integrated circuit (IC), a transistor, a silicon-controlled rectifier (SCR), a valve, a TFT, a capacitor, an inductor, a variable capacitor, a filter, a resistor, a diode, an LED, a micro electro mechanical systems (MEMS), a liquid crystal chip, etc., which should however not be construed as a limitation in the disclosure. The electronic apparatus 100a provided in this embodiment further includes a plurality of second bonding pads 125 (two of which are schematically shown), the second bonding pads 125 are disposed on the electronic device 120; the number of the second bonding pads 125 may correspond to the number of the first bonding pads 115, or the number of the second bonding pads 125 may be different from the number of the first bonding pads 115. The first bonding pads 115 and the second bonding pads 125 are structurally and electrically connected together through the solder material 150. That is, the electronic device 120 provided in this embodiment is, for instance, flip-chip bonded to the substrate 110.

Particularly, in this embodiment, the first spacer 130a is disposed between the electronic device 120 and the substrate 110, so as to maintain the height and uniformity of a gap between the electronic device 120 and the substrate 110 and support the electronic device 120 to prevent the electronic device 120 from being tilted. The first spacer 130a may be formed on the electronic device 120, on the substrate 110, or on the electronic device 120 and the substrate 110, which should however not be construed as a limitation in the disclosure. As shown in FIG. 1A and FIG. 1B, the first spacer 130a is disposed between the first bonding pads 115.

In addition, the electronic apparatus 100a provided in the embodiment further includes a second spacer 140a disposed between the first bonding pads 115. That is, the first spacer 130a and the second spacer 140a are disposed between the electronic device 120 and the substrate 110 and between the first bonding pads 115. Here, a material of the first spacer 130a and the second spacer 140a is, for instance, photoresist (i.e., a photo spacer), polymer (i.e., a polymer pattern), metal (i.e., a metal pattern), a film, a tape, a glue, or an underfill, which should however not be construed as a limitation in the disclosure.

In short, according to the embodiment of the disclosure, since the first spacer 130a and the second spacer 140a are disposed between the electronic device 120 and the substrate 110, the first spacer 130a and the second spacer 140a may serve to support the electronic device 120 and maintain the height and uniformity of the gap between the electronic device 120 and the substrate 110, so as to prevent the electronic device 120 from being tilted. As such, the electronic apparatus 100a provided in one or more embodiments of the disclosure may have a favorable structural reliability.

It should be noted here that the following embodiments use the reference numbers and part of the content of the foregoing embodiments. Similar numbers are used to indicate the same or similar devices, and the description of the same technical content is omitted. For the description of the omitted parts, reference may be made to the foregoing embodiments, and the following embodiments will not be repeat the same content.

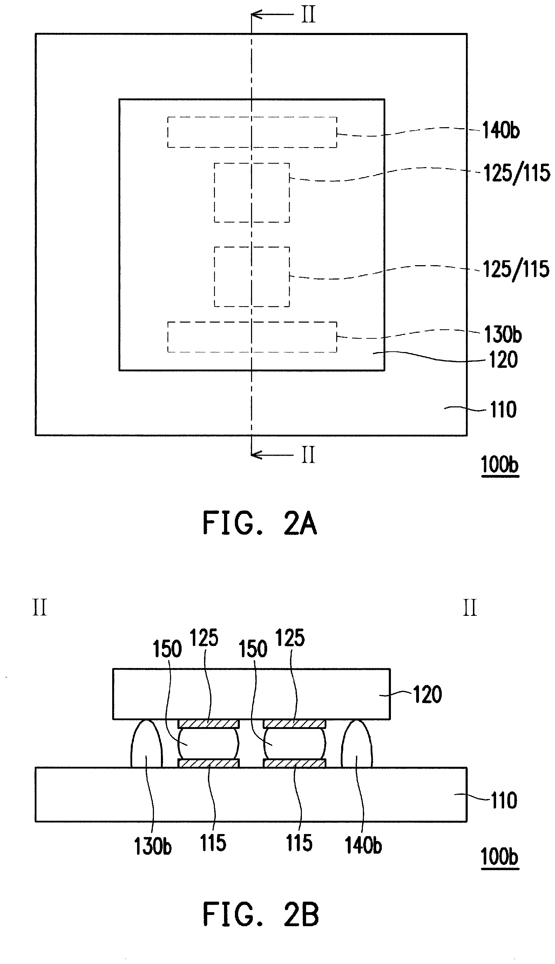

FIG. 2A is a schematic top view of an electronic apparatus according to another embodiment of the disclosure. FIG. 2B is a schematic cross-sectional view taken along a line II-II depicted in FIG. 2A. For clarity, the solder material 150 depicted in FIG. 2B is omitted from FIG. 2A. With reference to FIG. 1A, FIG. 2A, and FIG. 2B, an electronic apparatus 100b is similar to the electronic apparatus 100a depicted in FIG. 1A, while the difference therebetween lies in that the first bonding pads 115 provided in this embodiment are disposed between a first spacer 130b and a second spacer 140b. That is, the first spacer 130b and the second spacer 140b are located on opposite sides of the first bonding pads 115.

The size, the arrangement manner, and the number of the first spacer 130a, the first spacer 130b, the second spacer 140a, and the second spacer 140b are not limited in the disclosure. In an embodiment not shown in the drawings, the first spacer and the second spacer between the electronic device and the substrate may also be extended to the outside of the electronic device; alternatively, the number of the first spacer and the second spacer may be plural, and the first and second spacers separately surround the first bonding pads; all of the above belong to the scope of protection provided in the disclosure.

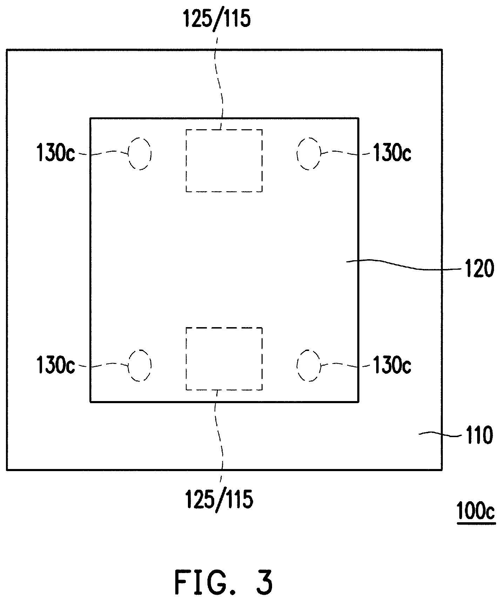

FIG. 3 is a schematic top view of an electronic apparatus according to another embodiment of the disclosure. For clarity, the solder material between the first bonding pads 115 and the second bonding pads 125 is omitted in FIG. 3. With reference to FIG. 1A and FIG. 3, in this embodiment, an electronic apparatus 100c is similar to the electronic apparatus 100a depicted in FIG. 1A, while the difference therebetween lies in that the number of a first spacer 130c in this embodiment is four, and the first spacers 130c are, for instance, ball-shaped spacers. As shown in FIG. 3, the four first spacers 130c are respectively arranged around the first bonding pads 115 and symmetrically arranged, which should however not be construed as a limitation in the disclosure. In other embodiments not shown in the drawings, the number of the first spacers may be, for instance, 2 to 10, and may be separately arranged around or between the first bonding pads, which still falls within the scope of the protection provided in the disclosure.

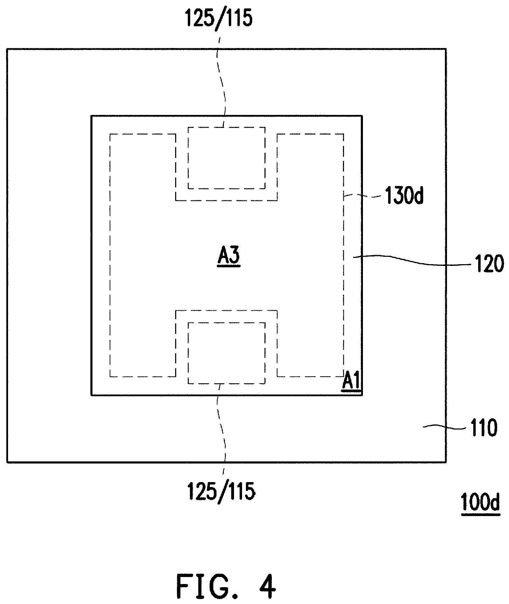

FIG. 4 is a schematic top view of an electronic apparatus according to another embodiment of the disclosure. For clarity, the solder material between the first bonding pads 115 and the second bonding pads 125 is omitted in FIG. 4. With reference to FIG. 1A and FIG. 4, an electronic apparatus 100d is similar to the electronic apparatus 100a depicted in FIG. 1A, while the difference therebetween lies in that the shape of a first spacer 130d in this embodiment is, an H shape and surrounds three side surfaces of the first bonding pads 115. Here, an area of the electronic device 120 is A1, an area of the first spacer 130d is A3, and A3>0.5A1. That is, the first spacer 130d occupies a significant area between the electronic device 120 and the substrate 110 to increase a support strength to support the electronic device 120 and maintain the height and uniformity of the gap between the electronic device 120 and the substrate 110, so as to prevent the electronic device 120 from being tilted. As such, the electronic apparatus 100d provided in one or more embodiments of the disclosure may have a favorable structural reliability. Here, the area is an orthogonal area on the substrate 110. Certainly, in other embodiments not shown in the drawings, the first spacer may also be shaped as a rectangle or of another shape, which should however not be construed as a limitation in the disclosure.

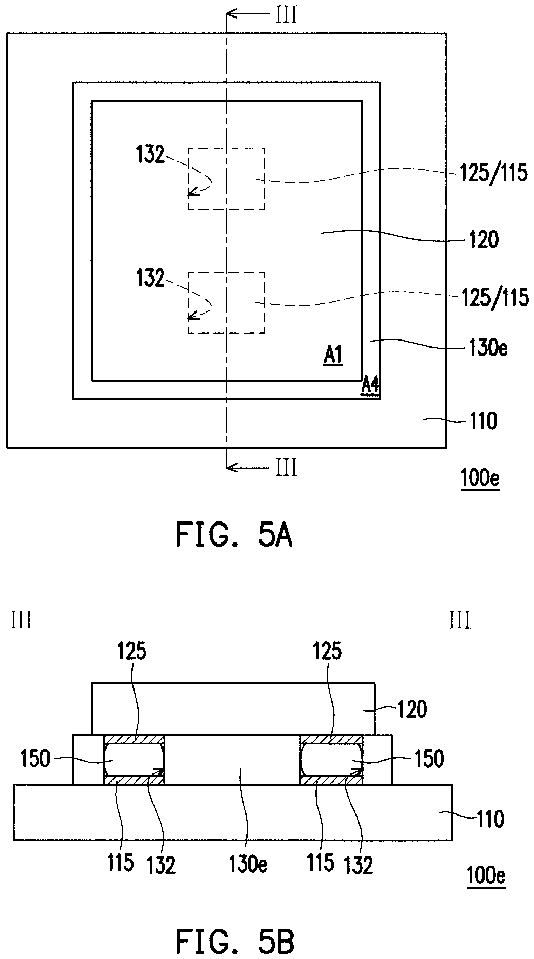

FIG. 5A is a schematic top view of an electronic apparatus according to another embodiment of the disclosure. FIG. 5B is a schematic cross-sectional view taken along a line III-III depicted in FIG. 5A. For clarity, the solder material 150 in FIG. 5B is omitted from FIG. 5A. With reference to FIG. 1A, FIG. 5A, and FIG. 5B, an electronic apparatus 100e is similar to the electronic apparatus 100a depicted in FIG. 1A, while the difference therebetween lies in that an orthogonal area of a first spacer 130e on the substrate 110 is greater than an orthogonal area of the electronic device 120 on the substrate 110 in this embodiment. Specifically, the first spacer 130e is, for instance, shaped as a rectangle and has two openings 132. The first bonding pads 115, the solder material 150, and the second bonding pads 125 are located within the openings 132, and the first spacer 130e surrounds the first bonding pads 115. The area of the electronic device 120 is A1, an area of the first spacer 130e is A4, and A4>0.5A1. That is, the first spacer 130e occupies a significant area between the electronic device 120 and the substrate 110 to increase the support strength to support the electronic device 120 and maintain the height and uniformity of the gap between the electronic device 120 and the substrate 110, so as to prevent the electronic device 120 from being tilted. As such, the electronic apparatus 100e provided in one or more embodiments of the disclosure may have a favorable structural reliability.

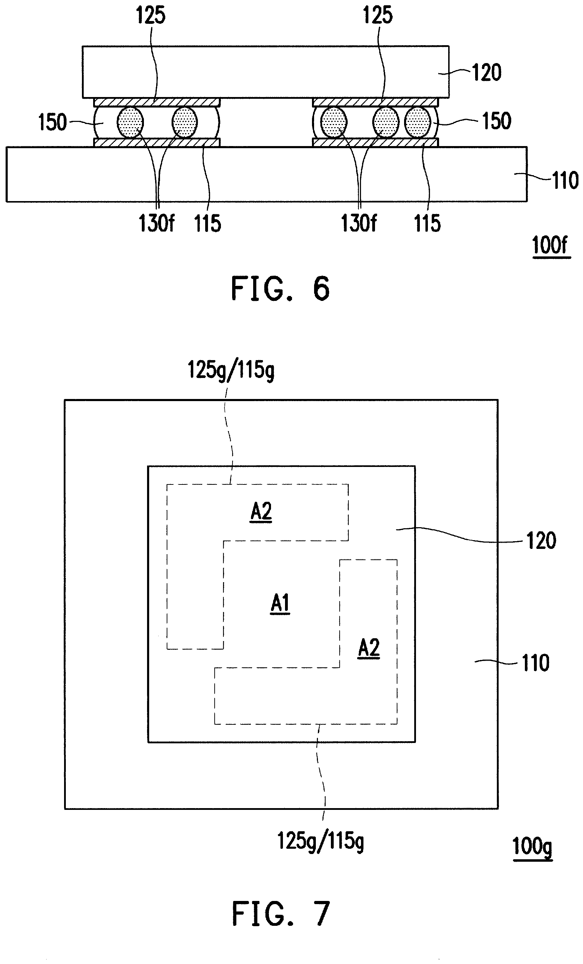

FIG. 6 is a schematic cross-sectional view of an electronic apparatus according to another embodiment of the disclosure. With reference to FIG. 1A and FIG. 6, an electronic apparatus 100f is similar to the electronic apparatus 100a depicted in FIG. 1A, while the difference therebetween lies in that a first spacer 130f in this embodiment is disposed between the first bonding pads 115 and the second bonding pads 125, wherein the first spacer 130f is, for instance, a solder ball. The first spacer 130f is added to the solder material 150 by screen printing or tin spraying, wherein the solder material 150 is, for instance, a solder paste. That is, the first spacer 130f is encapsulated by the solder material 150 to maintain the height and uniformity of the gap between the electronic device 120 and the substrate 110, so as to prevent the electronic device 120 from being tilted. As such, the electronic apparatus 100f provided in one or more embodiments of the disclosure may have a favorable structural reliability.

FIG. 7 is a schematic top view of an electronic apparatus according to another embodiment of the disclosure. The solder material between first bonding pads 115g and second bonding pads 125g is omitted in FIG. 7. With reference to FIG. 1A and FIG. 7, an electronic apparatus 100g in this embodiment is similar to the electronic apparatus 100a depicted in FIG. 1A, while the difference therebetween lies in that the shape of the first bonding pads 115g and the second bonding pads 125g is, for instance, an L shape in this embodiment, the area of the electronic device 120 is A1, an area of the first bonding pads 115g or the second bonding pads 125g is A2, and A2>0.3A1. That is, in this embodiment, the shape and the area of the first bonding pads 115g and the second bonding pads 125g are changed to increase the support strength to support the electronic device 120 and maintain the height and uniformity of the gap between the electronic device 120 and the substrate 110, so as to prevent the electronic device 120 from being tilted. As such, the electronic apparatus 100g provided in one or more embodiments of the disclosure may have a favorable structural reliability.

In other embodiments not shown in the drawings, the shape of the first bonding pads and the second bonding pads may be rectangular, for instance; the area of the electronic device is A1, an area of the second bonding pads is A2, and A2>0.3A1. Alternatively, the number of the first bonding pads and the number of the second bonding pads are greater than two, e.g., three, four, and so on; by increasing the number of the bonding pads, the height and uniformity of the gap between the electronic device and the substrate may be maintained, the electronic device may be supported, whereby the electronic device stays stable without being tilted.

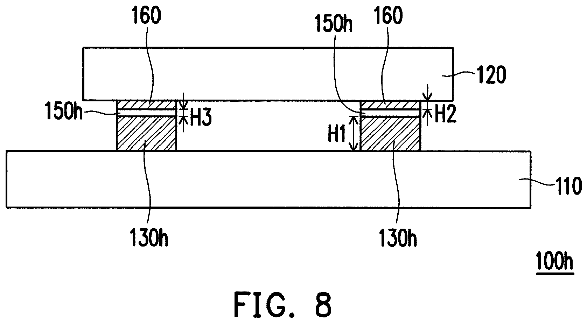

FIG. 8 is a schematic cross-sectional view of an electronic apparatus according to another embodiment of the disclosure. With reference to FIG. 8, in this embodiment, a spacer 130h is disposed on one of the electronic device 120 and the substrate 110, and the bonding pads 160 are disposed on the other of the electronic device 120 and the substrate 110. Specifically, the spacer 130h is, for instance, disposed on the substrate 110, and the bonding pads 160 are, for instance, disposed on the electronic device 120, wherein a solder material 150h is located between the spacer 130h and the bonding pads 160. The substrate 110 and the electronic device 120 are electrically connected through the spacer 130h, the solder material 150h, and the bonding pads 160. Here, the height of each spacer 130h is H1, the height of each bonding pad 160 is H2, the height of the solder material 150h is H3, and H1>H2>H3. Since the height HI of the spacer 130h is greater than the height H3 of the solder material 150h, during the reflowing process, there will be no excessive solder material 150h in a molten state, and the spacer 130h may support the electronic device 120, so as to further stabilize the electronic device 120 and prevent the electronic device 120 from being tilted. As such, the electronic apparatus 100h provided in one or more embodiments of the disclosure may have a favorable structural reliability.

To sum up, in one or more embodiments of the disclosure, the spacer is disposed between the electronic device and the substrate, so as to effectively control the height and uniformity of the gap between the electronic device and the substrate, whereby the electronic device may be prevented from being tilted. As a result, the electronic device provided in one or more embodiments of the disclosure may have a satisfactory structural reliability.

## Claims

1. An electronic apparatus (100a,100b,100c,100d,100e,100f,100g,100h), comprising:
a substrate (110);
a plurality of first bonding pads (115,115g), disposed on the substrate (110);
an electronic device (120), disposed on the substrate (110) and electrically connected to the first bonding pads (115,115g); and
a first spacer (130a,130b,130c,130d,130e,130f), disposed between the electronic device (120) and the substrate (110).

2. The electronic apparatus (100a) according to claim 1, wherein the first spacer (130a) is disposed between the first bonding pads (115).

3. The electronic apparatus (100a) according to claim 2, further comprising:
a second spacer (140a), disposed between the first bonding pads (115).

4. The electronic apparatus (100b) according to claim 1, further comprising:
a second spacer (140b), wherein the first bonding pads (115) arc disposed between the first spacer (130b) and the second spacer (140b).

5. The electronic apparatus (100d,100e) according to claim 1, wherein the first spacer (130d,130e) surrounds the first bonding pads (115).

6. The electronic apparatus (100f) according to claim 1, further comprising:
a plurality of second bonding pads (125), disposed on the electronic device (120), wherein the first spacer (130f) is disposed between the second bonding pads (125) and the substrate (110).

7. The electronic apparatus (100f) according to claim 6, wherein the first spacer (130f) comprises a solder ball.

8. The electronic apparatus (100g) according to claim 6, wherein an area of the electronic device (120) is A1, an area of the second bonding pads (125g) is A2, and A2>0.3A1.

9. The electronic apparatus (100a,100b,100c,100d,100e,100f,100g) according to claim 1, further comprising:
a plurality of second bonding pads (125,125g), disposed on the electronic device (120), wherein the number of the second bonding pads (125,125g) corresponds to the number of the first bonding pads (115,115g).

10. The electronic apparatus (100a,100b,100c,100d,100e,100f,100g) according to claim 9, wherein the first bonding pads (115,115g) and the second bonding pads (125g,125g) are structurally and electrically connected through a plurality of solder materials (150).

11. The electronic apparatus (100e) according to claim 10, wherein a shape of the first spacer (130e) is rectangular, the first spacer (130e) has two openings (132), the first bonding pads (115), the solder materials (150), and the second bonding pads (125) are located in the two openings (132), and the first spacer (130e) surrounds the first bonding pads (115).

12. The electronic apparatus (100e) according to claim 11, wherein an area of the electronic device (120) is A1, an area of the first spacer (130e) is A4, and A4>0.5A1.

13. The electronic apparatus (100g) according to claim 9, wherein a shape of the first bonding pads (115g) and the second bonding pads (125g) is an L shape, an area of the electronic device (120) is A1, and area of the second bonding pads (125g) is A2, and A2>0.3A1.

14. An electronic apparatus(100h), comprising:
a substrate (110);
an electronic device (120), disposed on the substrate (110);
a plurality of spacers (130h), disposed on one of the electronic device (120) and the substrate (110); and
a plurality of bonding pads (160), disposed on the other of the electronic device (120) and the substrate (110), wherein the substrate (110) and the electronic device (120) are electrically connected through the spacers (130h) and the bonding pads (160).

15. The electronic apparatus (100h) according to claim 14, further comprising a solder material (150h)located between one of the spacers (130h) and one of the bonding pads (160), wherein a thickness of one of the spacers (130h) is H1, a thickness of one of the bonding pads (160) is H2, a height of the solder material (150h) is H3, and H1>H2>H3.
